# FASCICULE DE BREVET EUROPEEN

(11) **EP 3 001 205 B1**
(45) Date de publication et mention de la délivrance du brevet: **01.02.2017**
(21) Numéro de dépôt: 15186788.4
(22) Date de dépôt: 25.09.2015
(51) Int. Cl.: G01R 15/18, G01R 1/04

(54) **DÉTECTEUR POUR RÉSEAU AÉRIEN ET RÉSEAU AÉRIEN COMPRENANT UN TEL DÉTECTEUR**
MESSWERTGEBER FÜR EIN ÜBERLANDLEITUNGSNETZ UND ÜBERLANDLEITUNGSNETZ MIT EINEM SOLCHEN MESSWERTGEBER
DETECTOR FOR AN OVERHEAD NETWORK AND OVERHEAD NETWORK COMPRISING SUCH A DETECTOR

(30) Priorité: 26.09.2014 FR 1459146
(43) Date de publication de la demande: 30.03.2016
(73) Titulaire: Schneider Electric Industries SAS, 92500 Rueil-Malmaison (FR)
(72) Inventeur: SOLEILLANT, Alexandre, 38050 GRENOBLE Cedex 09 (FR); HOUBRE, Pascal, 38050 GRENOBLE Cedex 09 (FR); CONTINI, Erick, 38050 GRENOBLE Cedex 09 (FR); MOREUX, Alain, 38050 GRENOBLE Cedex 09 (FR); CLEMENCE, Michel, 38050 GRENOBLE Cedex 09 (FR)
(74) Mandataire: Lavoix

(56) Documents cités:
- WO-A1-2010/042442
- WO-A1-2012/159698
- US-A- 4 646 006
- US-A1- 2012 038 446

## Description

La présente invention concerne un détecteur d'au moins une grandeur électrique dans un conducteur électrique, ainsi qu'un réseau aérien de distribution de courant électrique comprenant un tel détecteur.

Dans le domaine des réseaux aériens de distribution électrique, une des grandes responsabilités pour les entreprises du secteur est d'assurer le fonctionnement du réseau et de réduire au minimum le nombre des interruptions du courant. Lorsqu'une interruption intervient dans la distribution, afin de rétablir l'alimentation électrique le plus vite possible, il est nécessaire d'identifier et localiser le défaut. De plus, un inconvénient très commun dans la distribution est un déphasage du courant par rapport à la tension qui peut se produire le long de la ligne de transmission.

A ce sujet, il est connu d'utiliser, dans un réseau aérien, des détecteurs de défaut installés sur les lignes de transmission du réseau aérien. Leur mise en service peut avoir lieu lorsque le réseau de distribution est en fonction, c'est-à-dire lorsque les lignes de transmission transportent un courant de moyenne ou haute tension. De la même manière, la maintenance des détecteurs est réalisée dans une situation de fonctionnement du réseau. La mise en service et la maintenance de ces détecteurs sont des procédures difficiles et dangereuses. Il est donc important de prévoir un détecteur qui soit facile à installer, de façon fiable. En particulier, son accrochage aux lignes de transmission doit être pérenne, en produisant un effort de fermeture important et indépendant du diamètre du conducteur du réseau sur lequel il doit être accroché, et nécessiter peu de contrôles de la part des opérateurs.

La détection d'un défaut est réalisée avec une mesure du courant et une estimation du déphasage entre le courant et la tension transmis par la ligne. Le détecteur comporte donc des capteurs ou des composants électroniques qui nécessitent d'être alimentés électriquement. A ce propos, il est connu de WO-A-2010/042565 ou WO-A-2010/042422 d'utiliser un tore magnétique pour fournir de l'énergie électrique aux capteurs et aux composants électroniques du détecteur. Selon cette approche, le tore magnétique se ferme autour du conducteur électrique de la ligne de transmission et il est configuré pour induire un courant électrique dans les spires d'une bobine enroulée autour du tore magnétique.

Il est également connu, par exemple de US-A-2008/0077336 d'installer un dispositif de détection sur une ligne de haute tension, ce dispositif comprenant un tore magnétique d'alimentation pour un calculateur, le calculateur étant configuré pour traiter les paramètres mesurés par le détecteur et les transmettre à un concentrateur par une communication radio.

Enfin, il est connu de WO-A-2012/021478, d'utiliser un système de pinces et tore magnétique pour installer un détecteur sur une ligne de transmission d'un réseau aérien et pour alimenter les capteurs électriques du dispositif de détection. Les pinces se ferment autour du conducteur électrique grâce à un système vis/écrou. Ceci impose aux opérateurs de tourner avec une perche la vis du système vis/écrou, ce qui est long, fatiguant et potentiellement dangereux. Enfin, un bon accrochage dépend d'un bon serrage de la part de l'opérateur.

C'est à ces inconvénients qu'entend plus particulièrement remédier la présente invention en proposant un nouveau détecteur dans lequel l'installation est sécurisée, en particulier grâce à un système d'accrochage innovant.

A cet effet, l'invention concerne un détecteur d'au moins une grandeur électrique dans un conducteur électrique, le détecteur comprenant un bâti sur lequel est fixé un bloc mécanique. Le bloc mécanique inclut un tore magnétique, divisé en deux branches mobiles en rotation autour d'un axe défini par le bâti, entre une position écartée et une position fermée autour du conducteur électrique, le tore magnétique ayant une bobine enroulée autour d'au moins une des deux branches. Le bloc mécanique comprend également un capteur de courant, divisé en deux branches mobiles en rotation autour d'un axe défini par le bâti, entre une première position écartée et une position fermée autour du conducteur électrique, le capteur du courant réalisant une mesure de courant alternatif. Le bloc mécanique inclut aussi un élément de transmission d'effort de rotation au tore magnétique et au capteur de courant, cet élément étant pourvu d'au moins une portion apte à recevoir en appui le conducteur, et au moins deux pinces d'ancrage du détecteur sur le conducteur électrique, chaque pince étant mobile en rotation, autour d'un axe parallèle à l'axe de rotation des branches du tore magnétique et défini par le bâti, entre une position ouverte et une position verrouillée de la pince. Le détecteur comprend également une base, et au moins un dispositif électronique apte à transmettre un paramètre du courant détecté par le capteur de courant. Conformément à l'invention, l'élément de transmission d'effort est prolongé par une gâchette, alors que chaque pince d'ancrage présente une portion en contact avec la gâchette et porte un organe en saillie selon une direction parallèle à son axe de rotation, cet organe en saillie étant mobile avec la pince entre sa position ouverte et sa position verrouillée. De plus, un ressort est tendu entre l'organe en saillie et une partie fixe au bâti. Ce ressort exerce un couple de rotation sur la pince et tend à la déplacer vers sa position ouverte ou vers sa position verrouillée en fonction de la position angulaire de la pince par rapport à l'axe de rotation. De plus, entre la position ouverte et la position verrouillée, la pince passe par une position neutre ou l'organe en saillie, son axe de rotation et la partie fixe sont alignés et le ressort n'exerce pas de couple de rotation sur la pince.

Grâce à l'invention, les pinces d'ancrage assurent une fermeture pérenne sur le conducteur électrique, quel que soit son diamètre. Des ressorts produisent des efforts de serrage constants et indépendants de l'opérateur pour le système d'accrochage, ainsi que pour le système de mesure et d'auto-alimentation. De plus, l'invention prévoit une architecture du détecteur qui réalise la fermeture du bloc mécanisme en une seule opération, les courses des pinces, du tore et du capteur de courant étant indépendantes l'une des autres. La mise en service du détecteur est réalisée à l'aide d'une perche standard et apporte des avantages en termes de temps, fatigue, voire faisabilité par rapport aux solutions de l'art antérieur. L'auto-alimentation permet également de réaliser des mesures en permanence et de communiquer périodiquement les grandeurs mesurées à un centre de contrôle et donc d'offrir en parallèle un système de contrôle performant.

Selon des aspects avantageux mais non obligatoires de l'invention, un tel détecteur peut incorporer une ou plusieurs des caractéristiques suivantes, prises dans toute combinaison techniquement admissible :
- Lorsqu'elle est dans sa position verrouillée, chaque pince est en contact avec le conducteur électrique qui constitue une butée de fin de course de verrouillage pour chaque pince, quel que soit son diamètre.
- Lorsqu'elles sont en position fermées, les branches du tore magnétique et les branches du capteur de courant sont en appui l'une contre l'autre, indépendamment du diamètre du conducteur électrique.
- La distance radiale entre l'axe de rotation d'une pince et l'organe en saillie est au moins deux fois inférieure à la distance radiale entre l'axe de rotation de la pince et la partie fixe au bâti.
- Le détecteur comporte un système de capotage comprenant deux capots qui entourent le bloc mécanisme et sont mobiles avec celui-ci pour se fermer autour du conducteur, alors que le détecteur inclut au moins un organe de rappel élastique du tore magnétique et au moins un organe de rappel élastique du système de capotage vers leurs positions respectives fermées autour du conducteur électrique.
- Le capteur de courant est solidaire du tore magnétique.
- Le bloc mécanisme est pourvu de deux paires de pinces d'ancrage du détecteur sur le conducteur électrique, ces paires de pinces étant disposées de part et d'autre du tore magnétique, le long de l'axe de rotation de l'une de ses branches.
- Le capteur de courant est un enroulement de Rogowski.
- Le dispositif électronique comporte un capteur de tension dont la prise de potentiel est réalisée par les pinces d'ancrage et une carte électronique pourvue d'un calculateur pour traiter un signal de sortie du capteur de tension et générer un signal radio sur la base de ce signal.

L'invention concerne également un réseau aérien de transport de courant électrique comportant trois lignes de transmission, chaque ligne étant composée d'un conducteur électrique et pourvue d'un détecteur d'au moins un paramètre d'un courant alternatif dans le conducteur électrique, et un concentrateur apte à recevoir des signaux radio émis par les détecteurs et configuré pour traiter ces signaux radio. Ce réseau est caractérisé en ce qu'au moins un détecteur est tel que mentionné ci-dessus.

L'invention sera mieux comprise et d'autres avantages de celle-ci apparaitront plus clairement à la lumière de la description qui va suivre d'un mode de réalisation d'un détecteur et d'un réseau aérien conformes à son principe, donnée à titre d'exemple et faite en référence aux dessins annexés dans lesquels :
- la figure 1 est une vue en perspective d'un détecteur conforme à l'invention, verrouillé sur un conducteur électrique;
- la figure 2 est une vue en perspective d'un tore magnétique du détecteur de la figure 1, en configuration ouverte ;
- la figure 3 est une vue en perspective d'un capteur de courant du détecteur de la figure 1, en configuration ouverte ;
- la figure 4 est une vue partielle en perspective du détecteur de la figure 1 en configuration fermée, dont le système de capotage est omis pour la clarté du dessin ;
- la figure 5 est une vue partielle en perspective du détecteur de la figure 1 en configuration fermée, dont le système de capotage, une partie du bâti, certaines pinces d'ancrage, une branche du tore magnétique et une branche du capteur de courant sont omis pour la clarté du dessin ;
- la figure 6 est une coupe du disjoncteur de la figure 1 selon le plan VI à la figure 1, certains éléments étant omis pour la clarté du dessin ;
- la figure 7 est une représentation schématique et de côté du détecteur de la figure 1, qui explique le fonctionnement d'un ressort responsable du déplacement d'une pince d'ancrage de sa position ouverte vers sa position verrouillée ou réciproquement ;
- la figure 8 est une vue de côté du détecteur à la figure 4, lorsque le détecteur est dans une configuration ouverte ;
- la figure 9 est une vue de côté du détecteur à la figure 4 lorsque le détecteur est dans une configuration verrouillée autour d'un conducteur électrique de grand diamètre ;
- la figure 10 est une vue de côté du détecteur à la figure 4 lorsque le détecteur est dans une configuration verrouillée autour d'un conducteur électrique de petit diamètre ;
- la figure 11 est une représentation schématique d'un réseau aérien conforme à l'invention, chaque ligne de transmission incluant un détecteur conforme à l'invention tel que représenté aux figures 1 à 10.

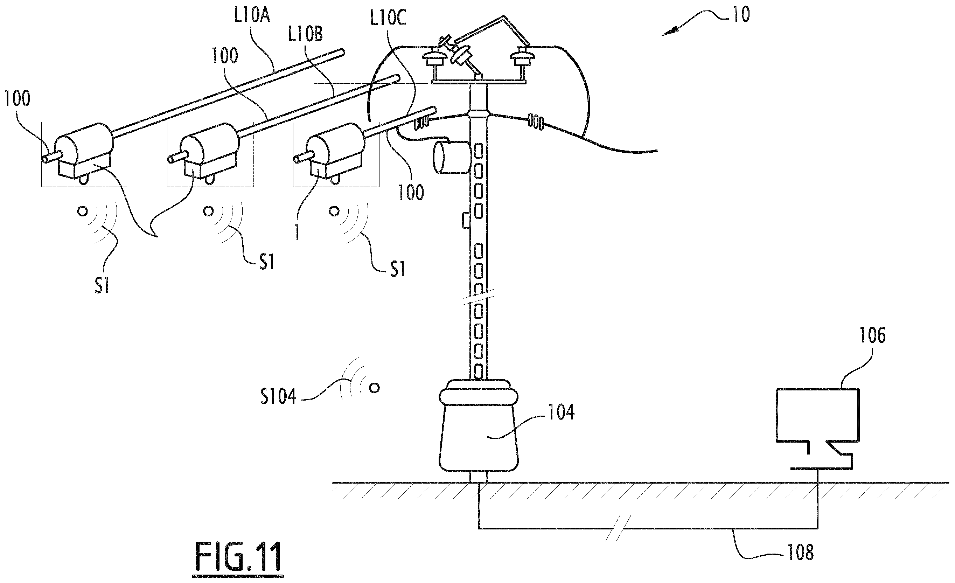

Le réseau aérien 10 de moyenne tension est représenté à la figure 11 et comporte trois lignes de transmission L10A, L10B et L10C, chaque ligne étant composée d'un conducteur électrique 100. Chaque ligne de transmission L10 est équipée d'un détecteur 1 d'au moins un paramètre d'un courant alternatif circulant dans le conducteur électrique 100, le détecteur étant configuré pour émettre des signaux radios S1. Le réseau aérien 10 est également équipé d'un concentrateur 104, apte à recevoir les signaux radios émis par les détecteurs 1 et configuré pour traiter ces signaux radios. S1 Lorsque le concentrateur 104 a analysé les données envoyées avec les signaux radios S1, il transmet les résultats à un centre de contrôle 106 à travers une ligne de connexion filaire 108 ou via des signaux radio de longue portée. Le concentrateur 104 peut également émettre des signaux radio de contrôle S104, à destination des détecteurs 1. Dans un autre mode de réalisation de l'invention, les fonctions du concentrateur 104 sont réalisée par un ou chaque détecteur 1.

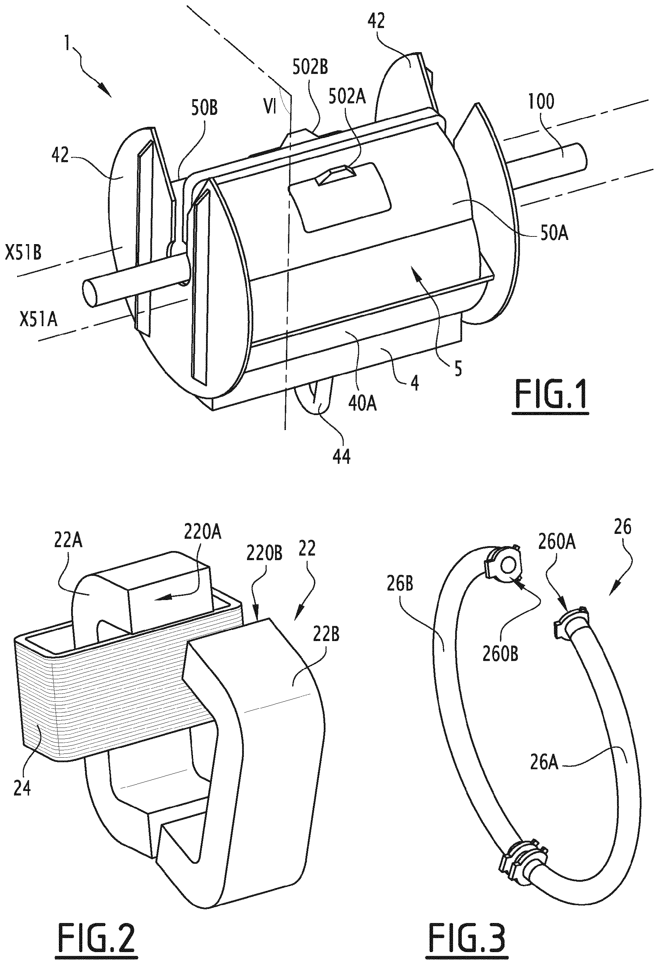

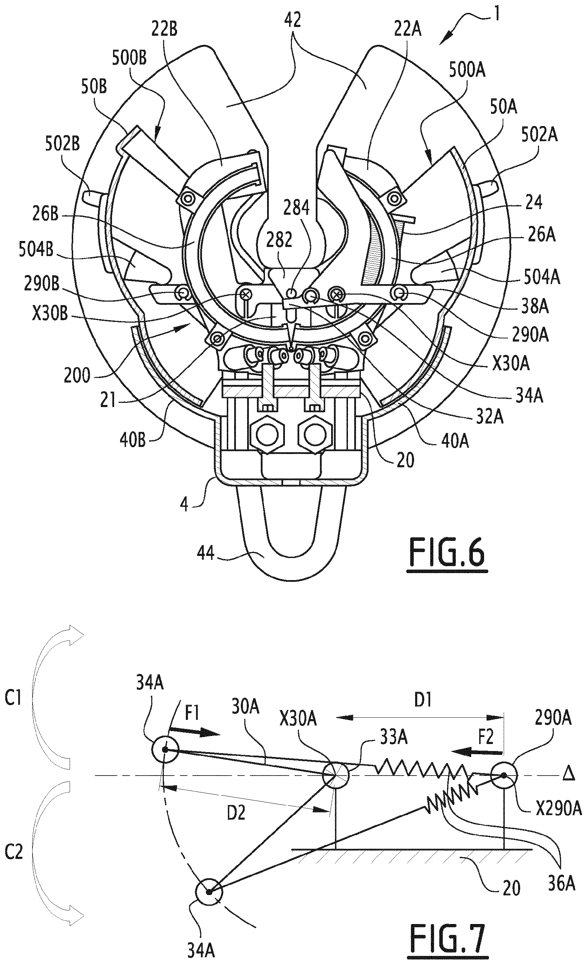

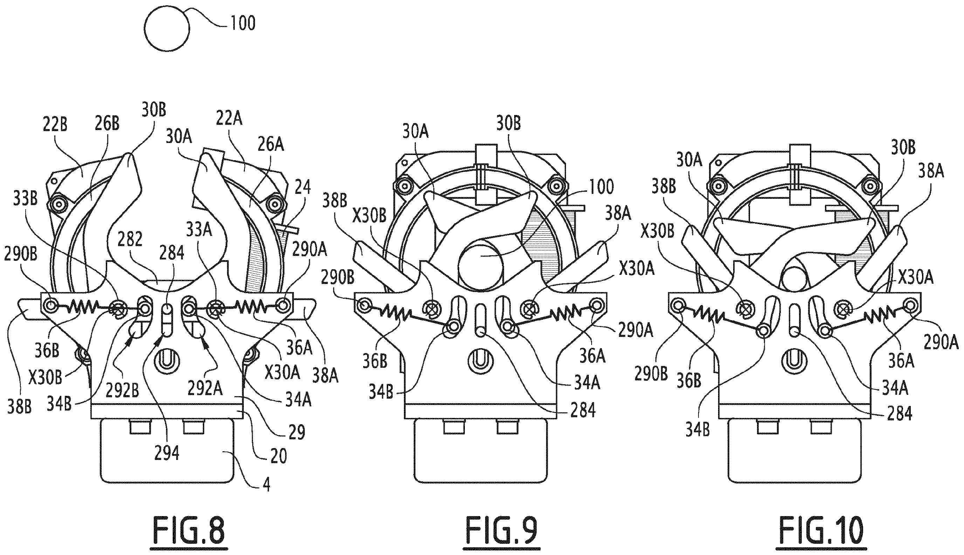

Le détecteur 1, représenté aux figures 1 à 10, est un dispositif de détection d'au moins un paramètre d'un courant alternatif dans le conducteur électrique 100. Ce paramètre peut être la phase, l'intensité ou la tension circulant dans le conducteur 100 d'une ligne L10. Ce détecteur 1 comporte un système de capotage 5 comprenant deux capots 50A et 50B mobiles en rotation, autour de deux axes parallèles X51 A et X51B défini par le détecteur 1, entre une position ouverte et une position fermée autour du conducteur électrique 100. On note 500A et 500B les surfaces de contact des capots 50A et 50B. Lorsque le système 5 est fermé, les surfaces 500A et 500B sont en appui l'une contre l'autre. Chaque capot 50A et 50B est pourvu d'une poignée 502A et 502B et d'un doigt interne 504A et 504B. Le système de capotage 5 est fixé sur une base 4 qui est pourvue de deux ailes latérales 40A et 40B qui permettent aux capots 50A et 50B de coulisser lors de l'ouverture. La base 4 comporte également deux flasques 42 pour le guidage latéral des capots 50A et 50B et un anneau d'ancrage 44 représenté uniquement aux figures 1 et 6, pour la clarté du dessin. Le système de capotage 5 entoure un dispositif électronique 6.

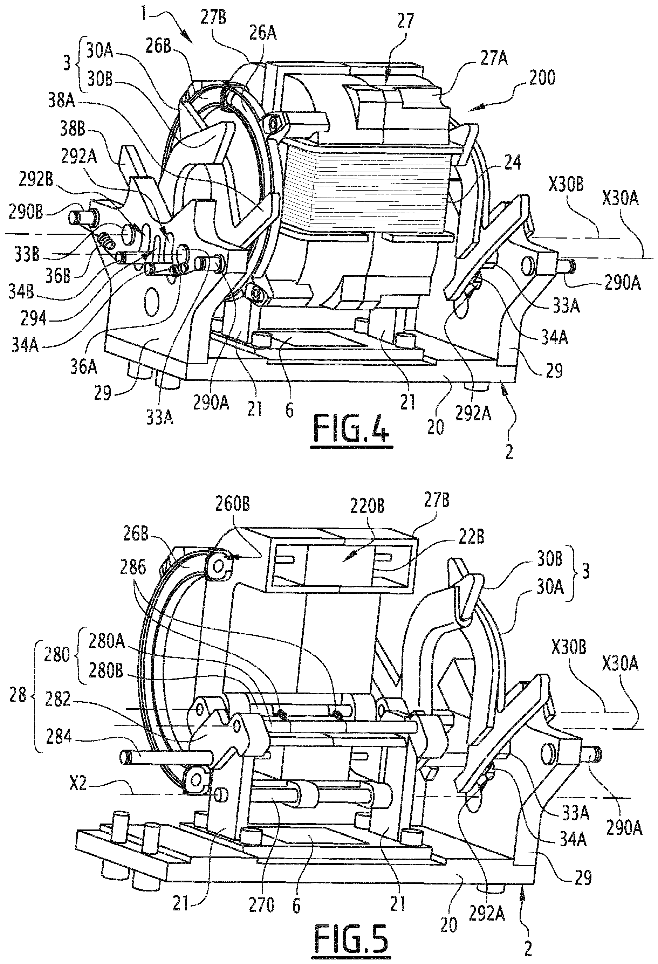

Le dispositif électronique 6 comporte un capteur de tension et une carte électronique pourvue d'un calculateur, le calculateur traitant un signal de sortie des capteurs de courant et/ou de tension et générant un signal radio sur la base de ces signaux. Seule l'enveloppe du dispositif électrique 6 est visible sur les figures 4 et 5, ses composants n'étant pas représentés pour la clarté des dessins.

Le système de capotage 5 entoure également un bâti 2 comportant une plaque 20 et deux paliers 21 qui sont en saillie perpendiculairement à la plaque 20. Les paliers 21 supportent un bloc mécanisme 200. Le bloc mécanisme 200 inclut un tore magnétique 22, une bobine 24, un capteur de courant 26, un couvercle 27 et un élément 28 de transmission d'effort. Le bloc mécanisme 200 inclut également deux paires de pinces 3.

Le tore magnétique 22 est divisé en deux branches 22A et 22B, ces branches étant mobiles en rotation, autour d'un axe commun X2 défini par le bâti 2, entre une position écartée et une position fermée autour du conducteur électrique 100. On note 220A et 220B les surfaces de contact des branches 22A et 22B. Lorsque, le tore 22 est fermé, les surfaces 220A et 220B sont en appui l'une contre l'autre. La bobine 24 est enroulée autour de la branche 22A du tore magnétique 22.

Le capteur de courant 26 est divisé en deux branches 26A et 26B, les branches étant mobiles en rotation, autour de l'axe X2, entre une position écartée et une position fermée autour du conducteur électrique 100. On note 260A et 260B les surfaces de contact des branches 26A et 26B. Lorsque le capteur 26 est fermé, les surfaces 260A et 260B sont en appui l'une contre l'autre. Le capteur de courant 26 réalise une mesure du courant alternatif. Dans l'exemple des figures, le capteur 26 est un enroulement de Rogowski. En variante, il peut s'agir de capteurs classiques ferro-magnétiques.

Le tore magnétique 22 est solidaire du capteur de courant 26 via le couvercle 27 qui les entoure. En particulier, la branche 22A du tore magnétique 22 est solidaire de la branche 26A du capteur de courant 26, en rotation autour de l'axe X2, via une branche 27A du couvercle 27 tandis que la branche 22B du tore magnétique 22 est solidaire de la branche 26B du capteur de courant 26, en rotation autour de l'axe X2, via une branche 27B du couvercle 27. Les deux branches 27A et 27B sont attachées à une barre 270 qui s'étend entre les deux paliers 21 parallèlement à la plaque 20 du bâti 2. En particulier, l'axe X2 de rotation du tore magnétique 22 et du capteur de courant 26 est défini par l'axe longitudinal de cette barre 270.

On note 280 un corps central de l'élément 28 de transmission d'effort. Le corps central 280 de l'élément 28 de transmission d'effort comprend deux arbres 280A et 280B. Deux ressorts 286 sont tendus entre les arbres 280A et 280B. Le corps central 280 est délimité de deux côtés par deux portions 282, aptes à recevoir en appui le conducteur électrique 100. Chaque portion 282 est prolongée axialement, à l'opposé des arbres 280A et 280B, par une gâchette 284. L'élément 28 est configuré pour transmettre un effort de rotation aux branches 27A et 27B du couvercle 27. Le couvercle 27, qui entoure et rend solidaire le tore magnétique 22 et le capteur de courant 26, transmet alors l'effort de rotation aux branches 22A et 22B ainsi qu'aux branches 26A et 26B.

Les paires de pinces 3 sont disposées de part et d'autre de l'élément 28 de transmission d'effort, le long de l'axe X2 du bâti 2. Les paires de pinces 3 comportent chacune deux pinces 30A et 30B. Chaque pince 30A est mobile en rotation, autour d'un axe X30A défini par le bâti 2, entre une position ouverte et une position verrouillée sur le conducteur 100. Egalement, chaque pince 30B est mobile, en rotation autour d'un axe X30B défini par le bâti 2, entre une position ouverte et une position verrouillée sur le conducteur 100. Les pinces 30A et 30B sont chacune pourvues d'une portion 32A et 32B qui est en appui contre la gâchette 284 de l'élément 28 de transmission d'effort. De plus, les pinces 30A et 30B portent chacune un organe 34A et 34B en saillie en parallèle des axes X30A et X30B, selon une direction parallèle respectivement à l'axe de rotation X30A et X30B. Les organes en saillie 34A et 34B sont mobiles avec les pinces 30A et 30B lors de leur déplacement entre leur position ouverte et leur position verrouillée sur le conducteur 100. Les axes X30A et X30B correspondent respectivement aux axes longitudinaux des arbres 280A et 280B de l'élément 28.

De plus, les pinces 30A et 30B sont installées de manière que, lorsqu'elles se déplacent vers la position verrouillée, elles se croisent jusqu'à venir en contact avec le conducteur électrique 100 qui constitue une butée de fin de course de leur verrouillage. Les pinces 30A et 30B sont chacune pourvues d'une extrémité 38A et 38B qui est en appui contre un doigt 504A ou 504B des capots 50A et 50B. Les paires de pinces 3 ont la fonction d'ancrer le détecteur 1 sur le conducteur électrique 100.

Le bâti 2 inclut deux parois latérales 29. Chaque paroi 29 est pourvue de deux pions fixes 290A et 290B, en saillie selon une direction parallèle à l'axe X2 et opposée aux paires de pinces 3. Chaque paroi 29 est également pourvue de deux lumières 292A et 292B, destinées à recevoir les organes en saillie 34A et 34B et d'une lumière 294 qui reçoit la gâchette 284.

Chaque pince 30A ou 30B porte un doigt circulaire 33A, respectivement 33B, aligné sur l'axe X30A ou X30B et qui s'étend du même côté que son organe en saillie 34A ou 34B. Chaque doigt 33A et 33B est monté rotatif dans un alésage circulaire de forme correspondante, ménagé dans la paroi 29 adjacente. Ainsi, chaque pince 30A ou 30B est articulé sur une paroi 29, autour de son axe de rotation X30A ou X30B, en engageant son doigt 33A ou 33B dans l'alésage correspondant qui est centré sur cet axe de rotation.

Les lumières 292A et 292B sont en forme d'arc de cercle respectivement centré sur les axes X30A et X30B, alors que la lumière 294 est rectiligne et perpendiculaire à la plaque 20.

Un ressort 36A est tendu entre l'organe en saillie 34A et le pion fixe 290A sur le côté de la paroi 29 opposé à la paire de pinces 3. De façon analogue, un ressort 36B est tendu entre l'organe en saillie 34B et le pion fixe 290B.

Les ressorts sont utilisés pour le déplacement des pinces 30A et 30B vers leur position ouverte ou vers leur position verrouillée. La figure 7 fait référence à la pince 30A visible à gauche de la figure 4 et décrit schématiquement le principe de fonctionnement pour l'ouverture et pour le verrouillage. L'explication qui va suivre est applicable à toutes les pinces du détecteur 1.

On note X290A l'axe longitudinal du pion 290A qui est parallèle aux axes X2 et X30A. On note Δ une droite perpendiculaire aux axes X30A et X290A et sécante avec ces axes. La droite Δ est parallèle à la plaque 20 du bâti 2. On note D1 la distance entre les axes X290A et X30A mesurée parallèlement à la droite Δ, c'est-à-dire radialement aux axes X30A et X290A. L'organe en saillie 34A, introduit dans la lumière 292A, est en rotation autour de l'axe de rotation X30A, l'organe 34A étant solidaire de la pince 30A. A la figure 7, la pince 30A est schématiquement représentée par une biellette qui définit un bras de levier et s'étend entre l'organe 34A et l'axe de rotation X30A. On note D2 la distance entre l'organe 34A et l'axe de rotation X30A mesurée radialement à l'axe X30A, c'est-à-dire la longueur du bras de levier. Dans cette représentation, la distance D1 est sensiblement égale à la distance D2 mais, en pratique, et comme représenté aux figures 4 et 6, la distance D2 est égale à environ 50% de la distance D1. On prévoit que la distance D2 est inférieure ou égale à la moitié de la distance D1. En effet, un rapport D2/D1 inférieur ou égal à 0,5 permet d'obtenir des forts couples de déplacement de la pince 30A, avec des faibles variations du ressort 36A.

Le ressort 36A exerce un effort F1 sur l'organe 34 en direction du pion fixe 290A et un effort F2 sur le pion fixe 290A en direction de l'organe 34, ces efforts F1 et F2 étant d'intensités égales et de directions opposées.

Lorsque l'organe 34A se trouve sur la droite Δ, les couples associés aux efforts F1 et F2 s'annulent et le ressort 36A ne produit aucun couple de déplacement de la pince 30A. Ceci correspond à une position neutre ou d'équilibre instable. Lorsque la pince 30A est dans une position ouverte ou semi-ouverte, l'organe 34A se trouve au-dessus de la droite Δ. Les efforts F1 et F2 provoquent un couple d'ouverture C1 sur la pince 30A, le couple C1 étant dans le sens des aiguilles d'une montre à la figure 7. Le couple C1 pousse ou maintient la pince 30A dans sa position totalement ouverte qui est donc une position stable. Lorsque le conducteur 100 est en appui sur la portion 282 de l'élément 28, la gâchette 284 appuie contre la portion 32A de la pince 30A qui donc est mise en rotation autour de l'axe X30A dans le sens inverse des aiguilles d'une montre à la figure 7. L'effort de la gâchette 284 s'oppose au couple C1 et pousse l'organe 34A au-dessous de la droite Δ. Alors, les efforts F1 et F2 provoquent alors un couple de verrouillage C2 sur la pince 30A, le couple C2 étant dans le sens inverse des aiguilles d'une montre à la figure 7. Le couple C2 pousse ou maintient la pince 30A vers sa position totalement verrouillé où la pince 30A est en contact avec le conducteur électrique 100 qui constitue une butée de fin de course de verrouillage, quel que soit son diamètre. La position verrouillée du détecteur 1 est une position stable. Ceci permet alors au détecteur 1 de s'accrocher à des conducteurs électriques des différents diamètres.

L'élément 28 transmet le couple généré par les ressorts 36A et 36B aux branches 27A et 27B du couvercle 27, comme expliqué ci-dessus. Les ressorts 286 contribuent aux phases d'ouverture et de fermeture du couvercle 27, en parallèle aux ressorts 36A et 36B. Le fonctionnement des ressorts 286 est analogue à celui du ressort 36A décrit ci-dessus. En particulier, en référence à la figure 5, trois points peuvent être identifiés sur chaque portion 282 : l'arbre 280A, la base de la gâchette 284 et l'arbre 280B. Ces trois points correspondent respectivement aux trois points de la figure 7, à savoir l'organe en saillie 34A, le doigt 33A et le pion 290A. Le ressort 286 est tendu entre les arbres 280A et 280B, l'arbre 280B est solidaire de la base de la gâchette 284 et une biellette qui forme un bras de levier est présente entre l'arbre 280A et la base de la gâchette 284. Les ressorts 286 produisent donc un couple C1 ou un couple C2 en fonction de la position de ces trois points.

De plus, le système de capotage 5 comporte deux ressorts 506 qui ont un fonctionnement analogue à celui décrit ci-dessus pour le ressort 36A. Les ressorts sont à l'intérieur des capotages 51A et 51B et sont ancrés sur les axes X51A et X51B.

Le couple produit par ces ressorts 506 et 286 est cohérent avec le couple produit par les ressorts 36A et 36B, de manière que tous les ressorts du détecteur 1 entrainent soit l'ouverture soit la fermeture des parties sur lesquelles ils agissent.

Avant l'installation, le détecteur 1 se trouve en configuration fermée, comme montré à la figure 1. En particulier, les capots 50A et 50B sont fermés, la surface 500A étant en appui contre la surface 500B, ainsi que le tore magnétique 22, la surface 220A étant en appui contre la surface 220B, et le capteur de courant 26, la surface 260A étant en appui contre la surface 260B. De plus, les pinces 30A et 30B sont alors dans leur configuration verrouillée, les organes en saillies 34A et 34B étant au-dessous des droites Δ dans la représentation de la figure 7, ce qui induit des couples de verrouillage C2, comme expliqué ci-dessus.

A partir de cette configuration, qui précède l'installation, le système de capotage 5 peut être ouvert en tirant sur les poignées 502A et 502B pour les écarter l'une de l'autre. Les capots 50A et 50B glissent sur les flasques 42 de guidage latéral et les doigts 504A et 504B viennent en appui contre les extrémités 38A et 38B des pinces 30A et 30B. Ceci met en rotation les pinces 30A et 30B autour des axes X30A et X30B et porte les organes en saillies 34A et 34B au-dessus des droites Δ, ce qui induit des couples d'ouverture C1, comme expliqué ci-dessus. L'ouverture des pinces 30A et 30B entraîne l'ouverture totale du bloc mécanisme 200, l'organe 28 transmettant l'effort des paires de pince 3 au couvercle 27 et donc au tore magnétique 22 et au capteur de courant 26. L'ouverture du détecteur 1 est réalisée en une seule opération. La configuration ouverte ainsi obtenue peut être considéré comme une configuration stable : cela découle du principe de fonctionnement des paires de pince 3.

Le détecteur 1 est alors prêt pour l'installation. Le détecteur 1 est hissé à la hauteur de la ligne de transmission 102 avec une perche qui vient s'ancrer à l'anneau d'ancrage 44. Le conducteur électrique 100 vient en appui contre les portions 282 de l'élément 28 de transmission d'effort et abaisse les gâchettes 284. Comme décrit ci-dessus, cela induit des couples de verrouillage C2 sur tout le bloc mécanisme 200. En particulier, les pinces 30A et 30B se ferment jusqu'à que elles viennent en appui contre le conducteur 100. Ceci assure l'ancrage du détecteur 1 au conducteur 100 de la ligne L10, ainsi que sa mise en fonctionnement. Le capteur de courant 26, qui est alors fermé, peut réaliser la mesure du courant, qui est ensuite transmise au dispositif électronique 6, dispositif alimenté par l'ensemble du tore 22 et de la bobine 24. Lorsque le dispositif 6 comporte un capteur de tension, la prise de potentiel de ce capteur est réalisée par les pinces d'ancrage 30A et 30B. Après avoir traité les signaux de sortie du capteur de courant et du capteur de tension, le dispositif 6 émet un signal radio S1 en direction du concentrateur 104, qui reçoit les signaux des trois détecteurs 1 montés sur les trois lignes 102.

Pour le démontage du détecteur 1, en utilisant la perche ancrée à l'anneau 44, le détecteur 1 est tiré vers le bas en biais dans la direction du conducteur 100 de manière que le conducteur 100 exerce un effort sur les pinces 30A et 30B jusqu'à que les ressorts du bloc 200 produisent des couples d'ouverture C1. Cela entraine l'ouverture du détecteur 1 qui peut donc être facilement démonté.

Les modes de réalisation et variantes envisagés ci-dessus peuvent être combinés pour générer de nouveaux modes de réalisation.

## Revendications

1. Détecteur (1) d'au moins une grandeur électrique dans un conducteur électrique (100), le détecteur comprenant :
- un bâti (2) sur lequel est fixé un bloc mécanisme (200) incluant :
- un tore magnétique (22), divisé en deux branches mobiles (22A, 22B) en rotation autour d'un axe (X2) défini par le bâti, entre une position écartée et une position fermée autour du conducteur électrique, le tore magnétique ayant une bobine (24) enroulée autour d'au moins une des deux branches,
- un capteur de courant (26), divisé en deux branches (26A, 26B) mobiles en rotation autour d'un axe défini par le bâti, entre une position écartée et une position fermée autour du conducteur électrique, le capteur de courant réalisant une mesure du courant alternatif,
- un élément (28) de transmission d'effort de rotation au tore magnétique et au capteur de courant, cet élément étant pourvu d'au moins une portion (282) apte à recevoir en appui le conducteur,
- au moins deux pinces d'ancrage (30A, 30B) du détecteur sur le conducteur électrique, chaque pince étant mobile en rotation, autour d'un axe (X3A, X30B) parallèle à l'axe (X2) de rotation des branches du tore magnétique et défini par le bâti, entre une position ouverte et une position verrouillée de la pince,
- une base (4),
- au moins un dispositif électronique (6) apte à transmettre un paramètre du courant détecté par le capteur de courant,
**caractérisé en ce que** :
- l'élément (28) de transmission d'effort est prolongé par une gâchette (284),
- chaque pince d'ancrage (30A et 30B) présente une portion (32A, 32B) en contact avec la gâchette,
- chaque pince porte un organe en saillie (34A, 34B) selon une direction parallèle à son axe de rotation, cet organe en saillie étant mobile avec sa pince entre la position ouverte et la position verrouillée,
- un ressort (36A, 36B) est tendu entre l'organe en saillie (34A, 34B) et une partie fixe (290A, 290B) au bâti (2),
- le ressort exerce un couple de rotation (C1, C2) sur la pince et tend à la déplacer vers la position ouverte ou vers sa position verrouillée, en fonction de la position angulaire de la pince par rapport à l'axe de rotation,
- entre la position ouverte et la position verrouillée, la pince passe par une position neutre où l'organe en saillie (34A, 34B), son axe de rotation (X30A, X30B) et la partie fixe (290A, 290B) sont alignés et le ressort n'exerce pas de couple de rotation sur la pince.

2. Détecteur selon la revendication 1, **caractérisé en ce que**, lorsque elle est dans sa position verrouillée, chaque pince (30A, 30B) est en contact avec le conducteur électrique (100) qui constitue une butée de fin de course de verrouillage pour chaque pince, quel que soit son diamètre.

3. Détecteur selon l'une des revendications précédentes, **caractérisé en ce que**, lorsqu'elles sont en position fermées, les branches (22A, 22B) du tore magnétique (22) et les branches (26A, 26B) du capteur de courant (26) sont en appui l'une contre l'autre, indépendamment du diamètre du conducteur électrique.

4. Détecteur selon l'une des revendications précédentes, **caractérisé en ce que** la distance radiale (D2) entre l'axe de rotation d'une pince (X30A, X30B) et l'organe en saillie (34A, 34B) est au moins deux fois inférieure à la distance radiale (D1) entre l'axe de rotation de la pince et la partie fixe (290A, 290B) au bâti (2).

5. Détecteur selon l'une des revendications précédentes, **caractérisé en ce qu'**il comporte un système de capotage (5) comprenant deux capots (50A, 50B) qui entourent le bloc mécanisme (200) et sont mobiles avec celui-ci pour se fermer autour du conducteur (100) et **en ce que** le détecteur inclut au moins un organe (286) de rappel élastique du tore magnétique et au moins un organe (506) de rappel élastique du système de capotage vers leurs positions respectives fermées autour du conducteur électrique.

6. Détecteur selon l'une des revendications précédentes, **caractérisé en ce que** le capteur de courant (26) est solidaire du tore magnétique (22).

7. Détecteur selon l'une des revendications précédentes, **caractérisé en ce que** le bloc mécanisme (200) est pourvu de deux paires de pinces (3) d'ancrage du détecteur sur le conducteur électrique (100), ces paires de pinces étant disposées de part et d'autre du tore magnétique (22), le long de l'axe (X2) de rotation de l'une de ses branches (22A, 22B).

8. Détecteur selon l'une des revendications précédentes, **caractérisé en ce que** le capteur de courant (26) est un enroulement de Rogowski.

9. Détecteur selon l'une des revendications précédentes, **caractérisé en ce que** le dispositif électronique (6) comporte :
- un capteur de tension dont la prise de potentiel est réalisée par les pinces d'ancrage (30A, 30B),
- une carte électronique pourvue d'un calculateur pour traiter un signal de sortie des capteurs de tension et/ou de courant et générer un signal radio sur la base de ces signaux.

10. Réseau aérien (10) de distribution de courant électrique comportant :
- trois lignes de transmission (L10A, L10B, L10C), chaque ligne (10) étant composée d'un conducteur électrique (100) et pourvue d'un détecteur d'au moins un paramètre d'un courant alternatif dans le conducteur électrique,
- un concentrateur (104) apte à recevoir des signaux radio émis par le détecteur et configuré pour traiter ces signaux radio
**caractérisé en ce qu'**au moins un détecteur (1) est selon l'une des revendications précédentes.

## Patentansprüche

1. Messwertaufnehmer (1) für mindestens eine elektrische Größe in einem elektrischen Leiter (100), wobei der Messwertgeber umfasst:
- ein Gestell (2), an dem ein Mechanismusblock (200) befestigt ist, der einschließt:
- einen Magnetkern (22), der in zwei Zweige (22A, 22B) aufgeteilt ist, die drehbar um eine von dem Gestell definierte Achse (X2) zwischen einer entfernten Position und einer um den elektrischen Leiter geschlossenen Position beweglich sind, wobei der Magnetkern eine um mindestens einen der zwei Zweige gewickelte Spule (24) aufweist,
- einen Stromaufnehmer (26), der in zwei Zweige (26A, 26B) aufgeteilt ist, die bezüglich der Drehung um eine von dem Gestell definierte Achse zwischen einer entfernten Position und einer um den elektrischen Leiter herum geschlossene Position beweglich sind, wobei der Stromaufnehmer eine Messung des Wechselstroms durchführt,
- ein Element (28) zur Übertragung einer Drehkraft an den Magnetkern und den Stromaufnehmer, wobei dieses Element mit mindestens einem Teil (282) ausgerüstet ist, das geeignet ist, den Leiter in Auflage aufzunehmen,
- mindestens zwei Klemmen (30A, 30B) zur Festlegung des Messwertaufnehmers an dem elektrischen Leiter, wobei jede Klemme um eine Achse (X30A, X30B) parallel zur Drehachse (X2) der Zweige des Magnetkerns und definiert durch das Gestell zwischen einer Offenstellung und einer verriegelten Stellung der Klemme drehbeweglich ist,
- einen Unterbau (4),
- mindestens eine elektronische Vorrichtung (6), die in der Lage ist, einen Parameter des von dem Stromaufnehmer abgetasteten Stroms zu übertragen,
**dadurch gekennzeichnet, dass**
- das Element (28) zur Übertragung einer Kraft von einem Drücker (284) verlängert wird,
- jede Klemme (30A und 30B) zur Festlegung einen Bereich (32A, 32B) in Kontakt mit dem Drücker aufweist,
- jede Klemme ein Element (34A, 34B) aufweist, das gemäß einer Richtung parallel zur ihrer Drehachse hervorspringt, wobei dieses vorspringende Element mit seiner Klemme zwischen der Offenstellung und der verriegelten Stellung beweglich ist,
- eine Feder (36A, 36B) zwischen dem vorspringenden Element (34A, 34B) und einem feststehenden Teil (290A, 290B) am Gestell (2) gespannt ist,
- die Feder ein Drehmoment (C1, C2) auf die Klemme ausübt und dazu führt, sie in die Offenstellung oder in ihre verriegelte Stellung abhängig von der Winkelposition der Klemme in Bezug auf die Drehachse zu bewegen,
- die Klemme zwischen der Offenstellung und der verriegelten Stellung über eine neutrale Stellung kommt, in der das vorspringende Element (34A, 34B), ihre Drehachse (X30A, X30B) und das feststehende Teil (290A, 290B) ausgerichtet sind und die Feder kein Drehmoment auf die Klemme ausübt.

2. Messwertaufnehmer nach Anspruch 1, **dadurch gekennzeichnet, dass** jede Klemme (30A, 30B) in Kontakt mit dem elektrischen Leiter (100) ist, wenn sie in ihrer verriegelten Stellung ist, wobei der elektrische Leiter einen Endanschlag für den Verriegelungsvorgang für jede Klemme bildet, wie auch immer sein Durchmesser ist.

3. Messwertaufnehmer nach einem der vorhergehenden Ansprüche, **dadurch gekennzeichnet, dass** die Zweige (22A, 22B) des Magnetkerns (22) und die Zweige (26A, 26B) des Stromaufnehmers sich gegeneinander abstützen, wenn sie in der geschlossenen Position sind, unabhängig vom Durchmesser des elektrischen Leiters.

4. Messwertaufnehmer nach einem der vorhergehenden Ansprüche, **dadurch gekennzeichnet, dass** der radiale Abstand (D2) zwischen der Drehachse (X30A, X30B) einer Klemme und dem vorspringenden Element (34A, 34B) mindestens zweimal kleiner als der radiale Abstand (D1) zwischen der Drehachse der Klemme und dem feststehenden Teil (290A, 290B) am Gestell (2) ist.

5. Messwertaufnehmer nach einem der vorhergehenden Ansprüche, **dadurch gekennzeichnet, dass** er ein Verkleidungssystem (5) aufweist, das zwei Abdeckungen (50A, 50B) umfasst, die den Mechanismusblock (200) umgeben und mit diesem beweglich sind, um sich um den Leiter (100) zu schließen, und dass der Messwertaufnehmer mindestens ein elastisches Element (286) zur Rückstellung des Magnetkerns und mindestens ein elastisches Element (506) zur Rückstellung des Verkleidungssystems in ihre jeweilige um den elektrischen Leiter geschlossene Position einschließt.

6. Messwertaufnehmer nach einem der vorhergehenden Ansprüche, **dadurch gekennzeichnet, dass** der Stromaufnehmer (26) mit dem Magnetkern (22) verbunden ist.

7. Messwertaufnehmer nach einem der vorhergehenden Ansprüche, **dadurch gekennzeichnet, dass** der Mechanismusblock (200) mit zwei Klemmenpaare (3) zur Festlegung des Messwertaufnehmers an dem elektrischen Leiter (100) versehen ist, wobei diese Klemmenpaare beidseitig des Magnetkerns (22) entlang der Drehachse (X2) eines seiner Zweige (22A, 22B) angeordnet sind.

8. Messwertaufnehmer nach einem der vorhergehenden Ansprüche, **dadurch gekennzeichnet, dass** der Stromaufnehmer (26) eine Rogowski-Wicklung ist.

9. Messwertaufnehmer nach einem der vorhergehenden Ansprüche, **dadurch gekennzeichnet, dass** die elektronische Vorrichtung (6) umfasst:
- mindestens einen Spannungsaufnehmer, dessen Potentialabgriff durch die Festlegungsklemmen (30A, 30B) gebildet wird,
- eine elektronische Leiterkarte, die mit einem Rechner zur Verarbeitung eines Ausgangssignals des Spannungsaufnehmers und/oder des Stromaufnehmers und zum Erzeugen eines Funksignals auf der Grundlage dieser Signale versehen ist.

10. Freileitungsnetz (10) zur Verteilung von elektrischem Strom, umfassend:
- drei Übertragungsleitungen (L10A, L10B, L10C), wobei jede Leitung (10) mit einem elektrischen Leiter (100) und einem Messwertaufnehmer mindestens eines Parameters eines Wechselstroms in dem elektrischen Leiter versehen ist,
- einen Konzentrator (104), der geeignet ist, von dem Messwertaufnehmer gesendete Funksignale zu empfangen und ausgebildet ist, diese Funksignale zu verarbeiten,
**dadurch gekennzeichnet, dass** mindestens ein Messwertaufnehmer (1) gemäß einem der vorhergehenden Ansprüche ausgebildet ist.

## Claims

1. A detector (1) for detecting at least one electric quantity in an electric conductor (100), the detector comprising:
- a frame (2) on which a mechanism unit is fixed (200), including:
- a magnetic toroid (22), divided into two branches (22A, 22B) rotatable around an axis (X2) defined by the frame, between a separated position and a position closed around the electric conductor, the magnetic toroid having a coil (24) wound around at least one of the two branches,
- a current sensor (26), divided into two branches (26A, 26B) rotatable around an axis defined by the frame, between a separated position and a position closed around the electric conductor, the current sensor performing an AC current measurement,
- an element (28) transmitting a rotational force to the magnetic toroid and the current sensor, the element being provided with at least one portion (282) able to receive the conductor by bearing,
- at least two clamps (30A, 30B) for anchoring the detector on the electric conductor, each clamp being rotatable around an axis (X30A, X30B) parallel to the rotation axis (X2) of the branches of the magnetic toroid and defined by the frame, between an open position and a locked position of the clamp,
- a base (4),
- at least one electronic device (6) able to send a parameter of the current detected by the current sensor,
**characterized in that**:
- the force transmitting element (28) is extended by a trigger (284),
- each anchoring clamp (30A, 30B) has a portion (32A, 32B) in contact with the trigger,
- each anchoring clamp bears a member (34A, 34B) protruding in a direction parallel to its axis of rotation, the protruding member being movable with its clamp between the open position and the locked position,
- a spring (36A, 36B) is stretched between the protruding member (34A, 34B) and a part (290B, 290B) fixed on the frame (2),
- the spring exerts a rotational torque (C1, C2) on the clamp and tends to move it toward the open position or its locked position as a function of the angular position of the clamp relative to the rotation axis,
- between the open position and the locked position, the clamp passes through a neutral position where the protruding member (34A, 34B), its axis of rotation (X30A, X30B) and the fixed part (290A, 290B) are aligned and the spring does not exert a rotational torque on the clamp.

2. The detector according to claim 1, **characterized in that**, when it is in its locked position, each clamp (30A, 30B) is in contact with the electric conductor (100), which constitutes an end-of-travel stop for the locking of each clamp, irrespective of its diameter.

3. The detector according to one of the preceding claims, **characterized in that** when they are in the closed position, the branches (22A, 22B) of the magnetic toroid (22) and the branches (26A, 26B) of the current sensor (26) bear against one another, independently of the diameter of the electric conductor.

4. The detector according to one of the preceding claims, **characterized in that** the radial distance (D2) between the rotation axis of a clamp (X30A, X30B) and the protruding member (34A, 34B) is at least two times smaller than the radial distance (D1) between the rotation axis of the clamp and the fixed part (290A, 290B) at the frame (2).

5. The detector according to one of the preceding claims, **characterized in that** it includes a covering system (5) comprising two covers (50A, 50B) that surround the mechanism unit (200) and are movable therewith to close around the conductor (100), and **in that** the detector includes at least one elastic return member (286) for the magnetic toroid and at least one elastic return member (506) for the covering system, returning them toward their respective positions closed around the electric conductor.

6. The detector according to one of the preceding claims, **characterized in that** the current sensor (26) is secured to the magnetic toroid (22).

7. The detector according to one of the preceding claims, **characterized in that** the mechanism unit (200) is provided with two pairs of anchoring clamps (3) for anchoring the detector on the electric conductor (100), these pairs of clamps being positioned on either side of the magnetic toroid (22), along the rotation axis (X2) of one of its branches (22A, 22B).

8. The detector according to one of the preceding claims, **characterized in that** the current sensor (26) is a Rogowski coil.

9. The detector according to one of the preceding claims, **characterized in that** the current sensor (6) includes:
- a voltage sensor, the potential connection of which is done by the anchoring clamps (30A, 30B),
- an electronic board provided with a computer to process an output signal of the voltage and/or current sensors and generate a radio signal based on those signals.

10. An overhead network (10) for distributing electricity, including:
- three transmission lines (L10A, L10B, L10C), each line (10) being made up of an electric conductor (100) and provided with a detector for at least one parameter of an AC current in the electric conductor,
- a concentrator (104) able to receive radio signals transmitted by the detectors and configured to process those radio signals,
**characterized in that** at least one detector (1) is according to one of the preceding claims.
